# EUROPEAN PATENT SPECIFICATION

(11) **EP 2 789 983 B1**
(45) Date of publication and mention of the grant of the patent: **25.05.2016**
(21) Application number: 14163878.3
(22) Date of filing: 08.04.2014
(51) Int. Cl.: G01D 3/02

(54) **Electric circuit**
Elektrische Schaltung
Circuit électrique

(30) Priority: 10.04.2013 FR 1353207
(43) Date of publication of application: 15.10.2014
(73) Proprietor: Vishay S.A., 06003 Nice Cedex 1 (FR)
(72) Inventor: Rabenarivo, Dio, 06200 Nice (FR); Lanot, Jean-Michel, 06800 Cagnes Sur Mer (FR)
(74) Representative: Manitz, Finsterwald & Partner GbR

(56) References cited:
- EP-A1- 1 801 965
- EP-A1- 2 068 119
- US-A1- 2010 102 878

## Description

The present invention relates to an electric circuit for operating a ratiometric sensor which is adapted to generate a sensor signal on the basis of a detected measurement parameter.

A ratiometric sensor is a sensor for the detection of a physical parameter or another measurement parameter, the sensor being adapted to generate a sensor signal on the basis of the measurement parameter to be determined, with the sensor signal not only depending on the detected measurement parameter, but also on the amplitude of the operation voltage with which the sensor is operated. Principally a linear relationship is present between the sensor signal and the operation voltage for such a ratiometric sensor when the measurement parameter is constant.

An exemplary ratiometric sensor is a Hall sensor which can detect the field strength of a magnetic field utilizing the Hall effect. The allowed range for the operation voltage is typically limited to a relatively small voltage interval for Hall sensors. The allowable operation voltage range can amount to 5 V +/- 0.5 V for an exemplary Hall sensor.

If such a sensor is operated with higher or lower voltages than the allowable operation voltage range the danger exists that the output signal of the sensor is no longer ratiometric with regard to the operation voltage or that the sensor signal no longer represents the value of the measurement parameter or that the sensor no longer functions or is even destroyed.

Document US 2010/0102878 A1 discloses an adjustment circuit which provides for an improved ratiometric characteristic of a physical quantity sensor. To this end the adjustment circuit comprises an amplifier circuit and additionally a reference amplifier circuit. A control circuit adjusts the gain of both the amplifier circuit and the reference amplifier circuit in such a way that the detection sensitivity of a sensor element is increased proportional to the power supply voltage.

Document EP 2 068 119 A1 teaches to use a reference signal to stabilize a constant driving signal provided by a driving circuit to a sensor element.

It is an object of the present invention to provide an electric circuit for operating a ratiometric sensor which also enables the operation of the sensor with such supply voltages which lie outside of the allowable operation voltage range of the sensor.

The subject matter satisfying this object provides an electric circuit having the features of claim 1.

An electric circuit for operating a ratiometric sensor in accordance with the invention is adapted to generate a sensor signal on the basis of a detected measurement parameter, and comprises an operation voltage amplifier, at least one signal amplifier and a control unit. The operation voltage amplifier has an input for receiving a supply voltage from a voltage source. The operation voltage amplifier is adapted to generate an operation voltage for the sensor from the supply voltage provided by the voltage source, with the ratio of the operation voltage to the supply voltage being determined by a settable voltage amplification factor. The signal amplifier has an input for receiving the sensor signal from the sensor and an output for outputting an output signal. The signal amplifier is adapted to generate the output signal from the sensor signal, with the ratio of the output signal to the sensor signal being determined by a settable signal amplification factor. The control unit likewise has an input for receiving the supply voltage from the voltage source. The control unit is adapted to generate at least one control signal for setting the voltage amplification factor and the signal amplification factor in dependence on the supply voltage. In this respect the voltage amplification factor is inversely proportional to the signal amplification factor (also referred to as anti-proportional or disproportional).

Such an inversely proportional relationship between the voltage amplification factor and the signal amplification factor means that the product of the voltage amplification factor and the signal amplification factor is constant (constant value k) or is substantially constant. The latter can be sufficient or even desired when certain non-linearities of the components or signals should be compensated (e.g. through the use of a lookup table, LUT).

Thus, it is possible to operate the circuit including the sensor with a supply voltage which is higher than the maximum allowable operation voltage of the sensor, with the output signal output by the circuit still having a ratiometric relationship with the supply voltage. Correspondingly, the ratio of the output signal to the applied supply voltage of the circuit is substantially only dependent on the detected measurement parameter, but not on the amplitude of the supply voltage itself. Eventually the electric circuit connected to the sensor thus behaves like a sensor having an extended allowable operation voltage range.

The control unit reduces the voltage amplification factor so far that the operation voltage provided by the operation voltage amplifier lies within the allowable operation voltage range of the sensor when the supply voltage exceeds the maximum allowable operation voltage of the sensor. At the same time, the signal amplification factor of the signal amplifier is increased by a corresponding quantity.

The circuit in accordance with the invention can generally be used for all types of ratiometric sensors. Particularly advantageously the use is in connection with Hall sensors in which the measurement parameter is a magnetic field strength.

Principally, the circuit can be designed for an operation with a single sensor or for an operation with a plurality of sensors, or also for an operation with a sensor having a plurality of signal outputs.

In accordance with an advantageous embodiment, said voltage amplification factor is reciprocal to the signal amplification factor. In this case, the voltage amplification factor is thus precisely the inverse value of the signal amplification factor. For a reciprocal relationship the product of the voltage amplification factor and the signal amplification factor always has the value 1 or substantially has the value 1.

Principally, the voltage amplification factor and the signal amplification factor can also be in a different inversely proportional relationship to one another, this means that the product of the voltage amplification factor and the signal amplification factor is not equal to 1, however, it is constant (k ≠ 1). In this manner, for example, a general amplification of the sensor signal can be realized.

Preferably, the voltage amplification factor is smaller than or equal to 1 and the signal amplification factor is larger than or equal to 1.

Preferably, the sensor signal and the output signal are formed by a respective voltage signal, with the signal amplifier being a voltage amplifier. This is, for example, the case for an embodiment adapted to a Hall sensor. Principally the sensor signal can, however, also be a current signal, with the signal amplifier being a current amplifier or an impedance converter (e.g. current/voltage transformer) in this case.

The control unit can be adapted to compare the supply voltage with at least one threshold value and to generate the at least one control signal for the setting of the voltage amplification factor and the signal amplification factor in dependence on the result of such a threshold comparison.

Particularly, in accordance with an advantageous embodiment the circuit can be operated with a supply voltage which lies within a predetermined voltage supply range, with the supply voltage range being divided into a plurality of intervals. A respective predetermined voltage amplification factor and a respective predetermined signal amplification factor are associated with each interval. The control unit is adapted to determine that interval which comprises the supply voltage. Furthermore, the control unit is also adapted to generate the at least one control signal for the setting of the voltage amplification factor and of the signal amplification factor in dependence on the determined interval.

Consequently, the voltage amplification factor and the signal amplification factor are not continuously changed, but are changed in discrete steps. This enables a simple adaptation from a circuit design aspect and furthermore ensures that the product of the voltage amplification factor and the signal amplification factor is constant and thus that also non-linearities can be avoided in the ratio of the output signal to the supply voltage for a constant measurement parameter.

In this connection, it is advantageous when each interval and the voltage amplification factor associated with this interval are selected such that the operation voltage generated by the operation voltage amplifier lies within an allowable operation voltage range for the sensor. It is thereby ensured that the sensor is always operated within specifications valid for the sensor.

It should be noted that the length of the interval does not necessarily have to be constant. In particular, it is also not required that each interval is dimensioned so that it completely utilizes the allowable operation voltage range for the sensor.

Preferably the control unit has at least one threshold value detector which is adapted to compare the supply voltage with at least one threshold value which separates neighboring intervals from one another. The threshold value detector enables a particularly simple association of the current supply voltage to one of the predetermined voltage intervals.

Advantageously, the control signal for the setting of the voltage amplification factor and the control signal for the setting of the signal amplification factor are identical for a respective interval. It is thereby prevented that a time shift arises for a change of the respective amplification factor on a change of the supply voltage (fluctuation). An erroneous setting of the amplification factors for which, for example, the voltage amplification factor associated with a first interval and the signal amplification factor associated with a second interval are set, are thereby particularly reliably avoided. It is thus ensured that the output signal is consistent in all operating situations.

In accordance with a further advantageous embodiment the operation voltage amplifier or the signal amplifier or both have a respective voltage divider arrangement having a plurality of switchable branches. Each of these branches can, for example, comprise at least one resistor. The branches can be switched directly or indirectly in dependence on the supply voltage such that a variable control voltage is provided at a node of the respective voltage divider arrangement on whose basis the voltage amplification factor or the signal amplification factor are set. A selection signal can in particular be generated in dependence on the supply voltage, with the mentioned branches being switched in dependence on the output signal, and with the variable control voltage at the node of the respective voltage divider arrangement corresponding to the already mentioned control signal of the control unit.

Hereby a particularly simple realization for the setting of the matching voltage amplification factor or signal amplification factor can be achieved from a circuit design aspect. Furthermore, a good equal behavior of the voltage amplifier and of the signal amplifier can be achieved at a simultaneously small temperature dependence, in particular when the operation voltage amplifier and the signal amplifier have like voltage divider arrangements.

Preferably, said node of the respective voltage divider arrangement is connected to a feedback path of the operation voltage amplifier or of the signal amplifier in order to hereby directly or indirectly set the voltage amplification factor or the signal amplification factor. For example, the operation voltage amplifier or the signal amplifier can have a respective operational amplifier (OpAmp) whose input is connected to the mentioned node of the respective voltage divider arrangement. It is in particular possible to connect the voltage divider arrangement of the operation voltage amplifier to the supply voltage and to an input of the operation voltage amplifier. Moreover, the voltage divider arrangement of the signal amplifier can be connected to an output of the signal amplifier and to an input of the signal amplifier. Hereby a feedback can be achieved, with such a circuit also being referred to as a non-inverting amplifier.

Preferably the operation voltage amplifier comprises a voltage divider arrangement having a plurality of resistors and the signal amplifier likewise has a voltage divider arrangement with a plurality of resistors, with the plurality of resistors of the operation voltage amplifier arrangement having the same values like the plurality of resistors of the signal amplifier. Hereby a particularly good equal behavior is achieved and component tolerances are only negligibly noticeable. The design of the voltage divider arrangement of the operation voltage amplifier and the design of the voltage divider arrangement of the signal amplifier are analog in this case; however, are adapted to set the voltage amplification factor inversely proportional to the signal amplification factor.

Alternatively or additionally, in accordance with a further advantageous embodiment the respective voltage divider arrangement has a parallel circuit composed of a plurality of resistors starting from said node, with a switch being associated with at least one of the plurality of resistors. The concerned resistor (or branch of a plurality of resistors) for generating the voltage signal can be switched active or non-active by means of the respective switch. The respective switch is hereby directly or indirectly controlled in dependence on the supply voltage (for example, via the mentioned selection signal). In this manner, a very good equal behavior for the setting of the voltage amplification factor and of the signal amplification factor can be achieved, since the amplification factors are substantially determined by the values of the resistors.

These measures are particularly advantageous in view of a high thermal stability and a low age-related drift of the components used. In particular, also non-linearities are avoided by the previously mentioned features which amongst other things relate to deviations in the manufacture of series which are frequently present for semiconductor components. Since the change of the amplification factors takes place with the aid of switches, deviations in the manufacture of series, which, for example, are made noticeable in the form of different amplification factors of transistors, have no influence on the ratiometry between the supply voltage and the output signal.

Further advantageous embodiments of the invention are mentioned in the dependent claims, the description and the drawings.

The invention will be described in detail in the following by means of embodiments with reference to the drawing. There is shown:
- Fig. 1: a block circuit diagram of a sensor comprising a circuit in accordance with the invention in accordance with a first embodiment,
- Figs. 2 to 6: a circuit diagram of an electric circuit in accordance with the invention in accordance with a second embodiment; and
- Fig. 7: a graphic illustration of different voltages and amplification factors in dependence on the supply voltage for an exemplary circuit.

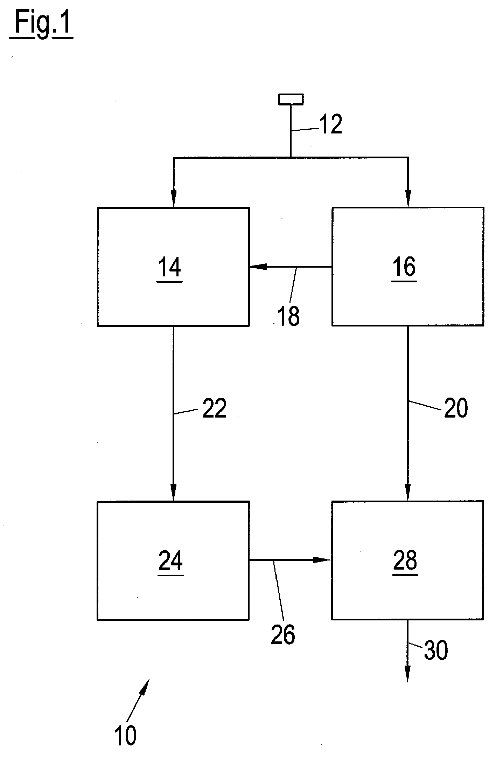

With reference to the block circuit diagram of Fig. 1, the general design of an exemplary circuit 10 in accordance with the invention will be described in the following. The circuit 10 comprises an operation voltage amplifier 14, a control unit 16, a Hall sensor 24 for detecting a magnetic field strength and a signal amplifier 28.

The operation voltage amplifier 14 and the control unit 16 receive a supply voltage 12 provided by a voltage source (non-illustrated) at respective inputs. The operation voltage amplifier 14 generates an operation voltage 22 on the basis of a control signal 18 provided by the control unit 16 which operation voltage 22 is provided at an operation voltage input of a Hall sensor 24. The Hall sensor 24 generates a sensor signal 26 whose amplitude depends on the detected magnetic field strength and on the operation voltage 22. For a constant magnetic field strength the sensor signal 26 is ratiometric with regard to the operation voltage 22, this means that there is a linear relationship between the operation voltage 22 and the sensor signal 26.

The sensor signal 26 is received as an input of the signal amplifier 28 and is amplified by the signal amplifier 28 with a variable signal amplification factor, with the signal amplification factor being set on the basis of a further control signal 20 provided by the control unit 16. The amplified sensor signal 26 is output as an output signal 30 at an output of the signal amplifier 28.

The control unit 16 generates the control signal 18 for the operational amplifier 14 such that the operation voltage 22 is always present within an allowable operation voltage range for the Hall sensor 24. The allowable operation voltage range of the Hall sensor 22 can lie between 4.5 V and 5.5 V for the present embodiment. The control signal 18 is generated such that the voltage amplification factor takes on a value G with the aid of the control unit 16. The signal amplifier 28 is controlled such that the signal amplification factor takes on the value 1/G with the aid of the control signal 20, i.e. precisely the reciprocal value of the voltage amplification factor.

When, for example, the supply voltage 12 has a value of 10 V the control unit 16 can set the voltage amplification factor of the operation voltage amplifier 14 with the aid of the control signal 18 to a value of 0.5, so that the operation voltage 22 has a value of 5 V. Correspondingly, the signal amplification factor then amounts to 1/0.5 = 2.

When the supply voltage, for example, merely has a value of 5 V, the control unit 16 can set the control signals 18, 20 so that the voltage amplification factor has a value of 1 and the signal amplification factor likewise has a value of 1.

It is thereby ensured that the output signal 30 is always ratiometric with regard to the supply voltage 12 as will be described in detail in the following.

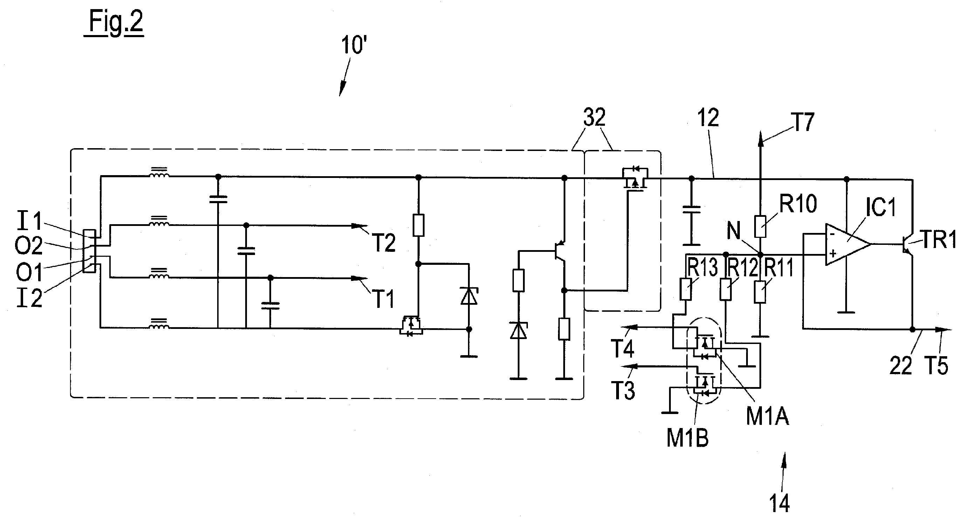

In the following a further embodiment of a circuit 10' in accordance with a further embodiment will be described in detail with reference to detailed circuit diagrams in accordance with Figs. 2 to 6. Since the circuit 10' in accordance with Figs. 2 to 6 is substantially based on the block circuit diagram of the circuit 10 in accordance with Fig. 1, the same reference numerals are used for same elements.

The circuit 10' illustrated in Figs. 2 to 6 comprises different part circuits which are connected amongst one another via connections T1 to T7, with respective connections having the same reference numeral being connected to one another.

In accordance with Fig. 2, the circuit 10' has a filter and protection circuit 32 which comprises inputs I1, I2 for receiving a supply voltage from a non-illustrated voltage source. Furthermore, the filter and protection circuit 32 comprises outputs O1, O2 at which a respective output signal 30, 30' is provided which will be explained in more detail in the following. The filter and protection circuit 32 comprises different filter units for the filtering of interference signals which comprise different inductances and capacitances (capacitors) as well as different protection units for protection against short circuits, low voltages and high voltages.

Furthermore, different capacitors, not illustrated in detail, are provided in a typical manner for the filtering and/or for the suppression of resonant frequencies also in the remaining part of the circuit 10'.

The circuit 10' comprises an operation voltage amplifier 14 which comprises an operational amplifier IC1 connected to the supply voltage 12, for example, of the type TLV271, and a bipolar transistor TR1, for example, of the type BDP949. The collector of the transistor TR1 is connected to the supply voltage 12, the base is connected to the output of the operational amplifier IC1 and the emitter is connected to the negative input of the operational amplifier IC1. A supply voltage 22 is provided at the connector T5.

The positive input of the operational amplifier IC1 is connected to one of the resistors R10 (10 kΩ), R11 (11.5 kΩ), R12 (25,5 kΩ) and R13 (18.2 kΩ) comprising the voltage divider arrangement. The resistors R11, R12 and R13 are switched in parallel to one another, as well as via a node N in series to the resistor R10, so that the voltage divider arrangement has three branches of resistors.

The resistor R10 is connected at its first connection to the supply voltage 12 and at its second connection via the node N1 to the positive input of the operational amplifier IC1, as well as to the first connections of the resistors R11, R12, R13. The second connection of the resistor R11 is directly connected to ground, while the second connection of the resistor R12 is connected by means of a MOS transistor M1B and the second connection of the resistor R13 is selectively connected to ground via a MOS transistor M1A. The two MOS transistors M1A, M1B serve as switches and are controlled via inputs T4 or T3. The MOS transistors M1A, M1B can, for example, be formed by a double MOS transistor of the type NDC7002N.

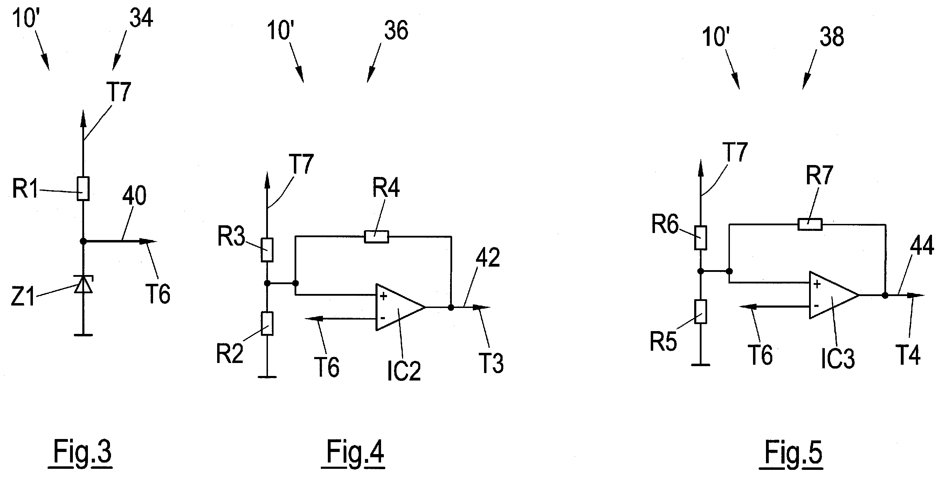

The circuit further comprises a reference voltage generation unit 34 (Fig. 3), a first threshold value detector 36 (Fig. 4) and a second threshold value 38 (Fig. 5) which are connected to the supply voltage 12 via a respective connection T7.

The reference voltage generation unit 34 (Fig. 3) comprises a Zener diode ZU1 having a breakdown voltage of 5.1 V, for example, of the type BZX84B5V1-V, as well as a resistor R1 (5 kΩ) for current limitations. The reference voltage generation unit 34 provides a reference voltage 40 having an amplitude of 5.1 V at the connection T6.

The first and second threshold voltage 36, 38 (Fig. 4 and 5) comprise operational amplifiers IC2 or IC3, for example, of the type LM2904DSMD, whose negative inputs are connected to the reference voltage 40 via the connections T6. The positive input of the operational amplifier IC2 (Fig. 4) is connected to the terminal formed by a voltage divider formed by the resistors R2 (10 kΩ) and R3 (10.5 kΩ), while the positive input of the operational amplifier IC3 (Fig. 5) is connected to the terminal formed between the voltage divider formed by the resistors R5 (10 kΩ) and R6 (15 kΩ). The positive inputs of the operational amplifier IC2, IC3 are further fed back via a resistor R4 (1MΩ) or R7 (1 MΩ) to the respective outputs of the operational amplifier IC2 or IC3.

The first threshold value detector 36 provides a first control signal 42 at the connection T3 when the supply voltage 12 amounts to at least 10.46 V. The second threshold value detector 38 provides a second control signal 44 at the connection T4 when the supply voltage 12 amounts to at least 12.75 V. The control signals 42, 44 serve as selection signals for the downstream MOS transistors M1A, M1B (Fig. 2), as will be described in detail in the following.

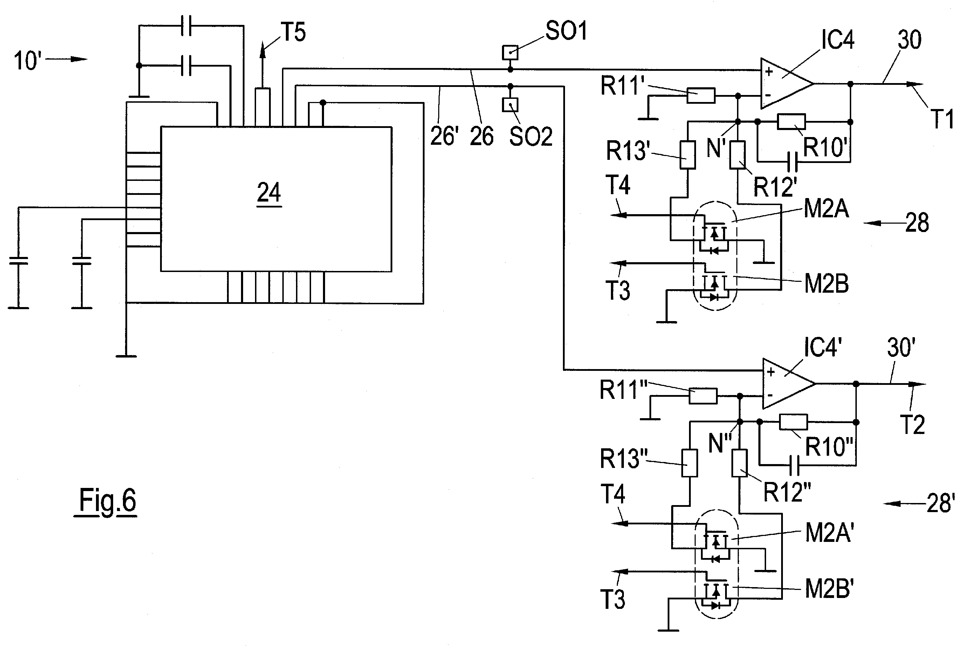

The circuit 10' in accordance with the invention further comprises a twofold Hall sensor 24, for example, of the type AS5263, which is supplied with the operation voltage provided by the operation voltage amplifier 14 at the connection T5 in accordance with Fig. 6. The Hall sensor 24 has two signal outputs SO1, SO2 at which a first sensor signal 26 and a second sensor signal 26' is provided.

The signal output SO1 is connected to a first signal amplifier 28. The first signal amplifier 28 comprises an operational amplifier IC4, for example, of the type TLV272, whose positive input is connected to the signal output SO1.

The negative input of the operation voltage amplifier IC4 is connected to a voltage divider arrangement which is designed like the voltage divider arrangement of the operation voltage amplifier 14 (Fig. 2). This voltage divider arrangement comprises the resistors R10' (10 kΩ), R11' (11.5 kΩ), R12' (25,5 kΩ) and R13' (18.2 kΩ). The resistors R11', R12' and R13' are switched in parallel to one another (with regard to ground) as well as in series to the resistor R10' via a node N'. The resistor R10' is connected at its first connection to the output of the operational amplifier IC4 and at its second connection via the node N' to the negative input of the operational amplifier IC4, as well as being connected to the first connections of the resistors R11', R12', R13'. The second connection of the resistor R11' is directly connected to ground. The second connection of the resistor R12' is connected via a MOS transistor M2B and the second connection of the resistor R13' is connected to ground via a MOS transistor M2A. The MOS transistors M2A, M2B in turn serve as switches and are selected in analogy to the MOS transistors M1A, M1B in accordance with Fig. 2 via the inputs T4 or T3, this means that they are selected by means of the control signals 42, 44 of the first threshold value detector 36 (Fig. 4) or the second threshold value detector 38 (Fig. 5). The MOS transistors M2A, M2B can, for example, also be formed by a double MOS transistor of the type NDC7002N in this instance.

The second signal amplifier 28' is connected to the signal output SO2 of the Hall sensor 24. Its design corresponds to the first signal amplifier 28, with the operational amplifier IC4' corresponding to the operational amplifier IC4, the resistors R10" to R13" corresponding to the resistors R10' to R13' and the MOS transistors M2A', M2B' corresponding to the MOS transistors M2A, M2B.

The signal amplifier 28 provides an output signal 30 via the connection T1 at the output O1 and the signal amplifier 28' provides an output signal 30' via the connection T2 at the output 02.

The reference voltage generation unit 34 (Fig. 3), the first threshold value detector 36 (Fig. 4), the second threshold value detector 38 (Fig. 5) and the respective switchable voltage divider arrangements of the operation voltage amplifier 14 (Fig. 2) and the signal amplifiers 28, 28' (Fig. 6) thus commonly form a control unit 16 which generates a respective control signal for the setting of the amplification factor of the operational amplifiers IC1, IC4, IC4' in dependence on the supply voltage 12 at the nodes N, N', N" (Fig. 2 and 6). The design particularly of the voltage divider arrangement of the operation voltage amplifier 14 and the voltage divider arrangement of the signal amplifiers 28, 28' is adapted to set a voltage amplification factor and a signal amplification factor which are inversely proportional to one another, namely reciprocal to one another.

In the following the corresponding functionality of the circuit 10' is explained in detail.

Due to the design of the circuit 10' including the threshold value detectors 36, 38 a working region of the supply voltage 12 from 8.8 V to 15 V results for the operation of the circuit 3 in accordance with the invention which is divided into three intervals 1, 2 and 3 within which intervals the operation voltage amplifier 14 and the signal amplifier 28, 28' are respectively operated with different amplification factors.

The lower boundary of the interval 1, as well as the upper boundary of the interval 3 are defined by respective switching means comprising further Zener diodes in the filter and protection circuit 32 which prevent an operation of the circuit outside of its working range.

When the supply voltage 12 lies between 8.8 V and 10.46 V and is thus present in the interval 1, the two threshold value detectors 36, 38 are present in the non-switched state, so that no control signal is output at the outputs T3, T4. Thus, the MOS transistors M1A, M1B of the operation voltage amplifier 14 and the MOS transistors M2A, M2B, M2A', M2B' of the signal amplifier 28, 28' lock so that currents merely flow through the resistors R10 and R11, R10' and R11' or R10" and R11" within the voltage divider arrangement. From this, a voltage amplification factor G of 0.54 (with regard to the operational amplifier IC1) results by calculation, so that the range of the operation voltage in the interval 1 reduces to a value between 4.71 V and 5.60 V.

When the supply voltage 12 lies between 10.46 V and 12.75 V and thus within the interval 2, the first threshold value detector 36 switches on and provides the first control signal 42 at the connection T3. Thereby the MOS transistors M1B, M2B and M2B' are transferred into a switched active state, so that the resistors R12, R12' and R12" are now switched in parallel to the resistors R11, R11' and/or R11" in the voltage divider arrangements. The voltage amplification factor G is thereby reduced to 0.44 by calculation, whereby it is ensured that the operation voltage is present within the allowable range also for the increased supply voltage.

The second threshold value detector 38 also switches active in addition to the first threshold value detector 36 and thus provides the second control signal 44 at the connection T4 when the supply voltage lies between 12.75 V and 15.00 V and thus within the interval 3. The second control signal 44 now additionally controls also the MOS transistors M1A, M2A and M2A' (switched active), so that the resistors R13, R13' or R13" are also additionally switched active in the voltage divider arrangements and thus all three resistors R11 to R13, R11' to R13' or R11" to R13" are switched in parallel. Thereby the voltage amplification factor G reduces to 0.36 by calculation and the increased supply voltage in turn reduces to a voltage range suitable for the operation of the Hall sensor 24.

In the following table the ranges of the supply voltage 12, the operation voltage amplification factors G (with regard to the operational amplifier IC1), the signal amplification factors 1/G (with regard to the operational amplifiers IC4, IC4'), as well as the resulting ranges for the operation voltage 22 of the Hall sensor 24 are respectively provided for the respective intervals 1 to 3.

| Interval | 1 | 2 | 3 |
|---|---|---|---|
| Supply voltage (12) | 8.80 V to 10.46 V | 10.46 V to 12.75 V | 12.75 V to 15.00 V |
| G | 0.54 | 0.44 | 0.36 |
| 1/G | 1.87 | 2.26 | 2.81 |
| Operation voltage (22) | 4.71 V to 5.60 V | 4.62 V to 5.64 V | 4.54 V to 5.34 V |

It should be noted that the values provided were substantially calculated on the basis of the resistor value of the voltage divider arrangement for a simpler comprehension thereof. Due to further voltage losses not considered in this example, such as at transistors or at operational amplifiers it is ensured that the operation voltage amounts to between 4.5 and 5.5 V in practice.

It is understood that the mentioned number values (e.g. for the resistors R10 to R13) are to be understood purely by way of example in connection with the embodiment in accordance with Figs. 2 to 6.

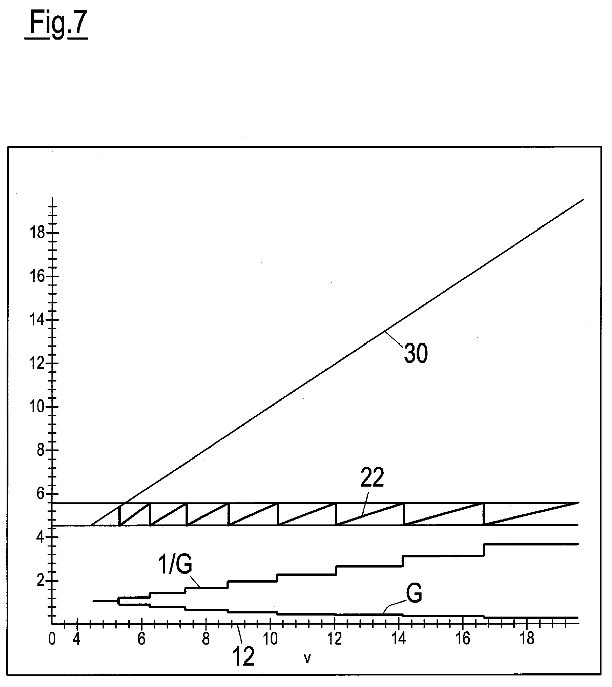

In the diagram of Fig. 7 different voltages and amplification factors are shown for a circuit in accordance with the invention in accordance with a further non-illustrated embodiment. The circuit on which this is based is designed for a larger supply voltage range of approximately 4.5 V to 19.5 V in contrast to the second embodiment of Figs. 2 to 6, which can be achieved by a simple deviation of the circuit 10' of the previously described second embodiment by an increase of the number of supply voltage intervals, with additional threshold value detectors and additional branches being provided in the voltage divider arrangement of the operation voltage amplifiers 14 and of the signal amplifiers 28, 28'.

In the diagram of Fig. 7 the dependencies of the operation voltage 22 and the output signal 30 on the supply voltage 12 (X-axis, in Volt) are displayed for a constant measurement parameter with the scaling being Volt on the Y-axis. Furthermore, also the progression of the voltage amplification factor G and of the signal amplification factor 1/G are shown with the corresponding unit of the Y-axis being dimensionless in this example.

With reference to the saw-tooth-like progression of the operation voltage 22 it can be recognized that the operation voltage 22 is reduced approximately from the maximum allowable voltage value to the minimum allowable voltage value on arriving at an interval boundary. Due to the ratiometric behavior of the Hall sensor this also brings about a corresponding reduction of the sensor signal provided at the signal outputs of the Hall sensor. However, since at the same time the signal amplification factor 1/G is increased with the start of each interval this decrease of the sensor signal is completely compensated. Thus, the output signal 30 provided at the outputs has the linear extent illustrated in Fig. 7.

Thus, it is possible to increase the effective supply voltage range for the operation of a ratiometric sensor on maintenance of the ratiometric relationship between the supply voltage of the circuit and the output signal provided by the circuit with the aid of the circuit in accordance with the invention.

### List of reference numerals

- 10, 10': circuit
- 12: supply voltage
- 14: operation voltage amplifier
- 16: control unit
- 18, 20: control signal
- 22: operation voltage
- 24: Hall sensor
- 26, 26': sensor signal
- 28, 28': signal amplifier
- 30, 30': output signal
- 32: filter and protection circuit
- 34: reference voltage generation unit
- 36: first threshold value detector
- 38: second threshold value detector
- 40: reference voltage
- 42: first control signal
- 44: second control signal
- I1, I2: input
- IC1-IC4, IC4': operational amplifier
- M1A, M1B, M2A, M2B, M2A', M2B': MOS transistor
- N, N', N": nodes
- O1, O2: output
- R1-R7, R10-R13, R10'-R13', R10"-R13": resistor
- SO1, SO2: signal output
- T1-T7: connection
- TR1: transistor
- Z1: Zener diode

## Claims

1. An electric circuit for operating a ratiometric sensor (24) which is adapted to generate a ratiometric sensor signal (26, 26') on the basis of a detected measurement parameter and which has an allowable operation voltage range outside of which the sensor signal (26, 26') is no longer ratiometric, comprising:
an operation voltage amplifier (14) which has an input for receiving a supply voltage (12) from a voltage source, wherein the operation voltage amplifier (14) is adapted to generate an operation voltage (22) for the sensor (24) from the supply voltage (12) provided by the voltage source, wherein the ratio of the operation voltage (22) to the supply voltage (12) is determined by a settable voltage amplification factor;
at least one signal amplifier (28, 28') which has an input for receiving the ratiometric sensor signal (26, 26') from the sensor (24) and an output (O1, 02) for outputting an output signal (30, 30'), wherein the signal amplifier (28, 28') is adapted to generate the output signal (30, 30') from the ratiometric sensor signal (26, 26'), wherein the ratio of the output signal (30, 30') to the ratiometric sensor signal (26, 26') is determined by a settable signal amplification factor; and
a control unit (16) which likewise has an input for receiving the supply voltage (12) from the voltage source, wherein the control unit (16) is adapted to generate at least one control signal (18, 20) for setting the voltage amplification factor and the signal amplification factor in dependence on the supply voltage (12);
wherein the voltage amplification factor is inversely proportional to the signal amplification factor; and
wherein the control unit (16) is adapted to reduce the voltage amplification factor so far that the operation voltage (22) provided by the operation voltage amplifier (14) lies within the allowable operation voltage range when the supply voltage (12) exceeds a maximum allowable operation voltage of the ratiometric sensor (24).

2. An electric circuit in accordance with claim 1, wherein the voltage amplification factor is reciprocal to the signal amplification factor.

3. An electric circuit in accordance with claim 1 or claim 2, wherein the ratiometric sensor signal (26, 26') and the output signal (30, 30') are formed by a respective voltage signal; and wherein the signal amplifier (28, 28') is a voltage amplifier.

4. An electric circuit in accordance with any one of the preceding claims, wherein the voltage amplification factor is smaller than or equal to 1; and wherein the signal amplification factor is greater than or equal to 1.

5. An electric circuit in accordance with any one of the preceding claims, wherein the circuit can be operated with a supply voltage (12) which lies within a predetermined supply voltage range; wherein the supply voltage range is divided into a plurality of intervals; wherein a respective predetermined voltage amplification factor and a respective predetermined signal amplification factor are associated with each interval; wherein the control unit (16) is adapted to determine that interval which comprises the supply voltage (12); and wherein the control unit (16) is adapted to generate the at least one control signal (18, 20) for setting the voltage amplification factor and the signal amplification factor in dependence on the determined interval.

6. An electric circuit in accordance with claim 5, wherein each interval and the voltage amplification factor associated with this interval are selected such that the operation voltage (22) generated by the operation voltage amplifier (14) lies within the allowable operation voltage range for the sensor (24).

7. An electric circuit in accordance with claim 6, wherein the control unit (16) has at least one threshold value detector (36, 38) which is adapted to compare the supply voltage (12) with at least one threshold value which separates neighboring intervals from one another.

8. An electric circuit in accordance with claim 7, wherein the control signal (18) for the setting of the voltage amplification factor and the control signal (20) for the setting of the signal amplification factor of a respective interval are identical.

9. An electric circuit in accordance with any one of the preceding claims, wherein the operation voltage amplifier (14) and/or the signal amplifier (28, 28') comprise a respective voltage divider arrangement having a plurality of switchable branches which are selectively switchable in dependence on the supply voltage (12) such that a variable control voltage is provided at a node (N, N', N") of the respective voltage divider arrangement on the basis of which the voltage amplification factor or the signal amplification factor is set.

10. An electric circuit in accordance with claim 9, wherein the operation voltage amplifier (14) comprises a voltage divider arrangement having a plurality of resistors (R10-R13) and the signal amplifier (28, 28') comprises a voltage divider arrangement having a plurality of resistors (R10'-R13', R10"-R13"), with the plurality of resistors (R10-R13) of the operation voltage amplifier having the same values as the plurality of resistors (R10'-R13', R10"-R13") of the signal amplifier.

11. An electric circuit in accordance with claim 9 or claim 10, wherein the respective voltage divider arrangement comprises a parallel circuit of plurality of resistors (R11-R13, R11'-R13', R11 "-R13") starting from the mentioned node (N, N', N"); wherein a switch (M1A, M1B, M2A, M2B, M2A', M2B') is associated with at least one of the plurality of resistors by means of which switch the respective resistor (R11-R13, R11'-R13', R11 "-R13") is switchable active or non-active for the generation of the control voltage, with the respective switch (M1A, M1B, M2A, M2B, M2A', M2B') being controllable in dependence on the supply voltage (12).

12. An electric circuit in accordance with any one of the preceding claims, wherein the circuit (10, 10') comprises the ratiometric sensor (24).

13. An electric circuit in accordance with any one of the preceding claims, wherein the ratiometric sensor is a Hall sensor (24).

## Patentansprüche

1. Elektrische Schaltung zum Betreiben eines ratiometrischen Sensors (24), der geeignet ist, um ein ratiometrisches Sensorsignal (26, 26') auf der Grundlage eines detektierten Messparameters zu erzeugen und der einen zulässigen Betriebsspannungsbereich aufweist, außerhalb dessen das Sensorsignal (26, 26') nicht mehr ratiometrisch ist, umfassend:
einen Betriebsspannungsverstärker (14), der einen Eingang zum Empfangen einer Versorgungsspannung (12) von einer Spannungsquelle aufweist, wobei der Betriebsspannungsverstärker (14) geeignet ist, um aus der Versorgungsspannung (12), die von der Spannungsquelle bereitgestellt wird, eine Betriebsspannung (22) für den Sensor (24) zu erzeugen, wobei das Verhältnis der Betriebsspannung (22) zu der Versorgungsspannung (12) durch einen einstellbaren Spannungsverstärkungsfaktor bestimmt wird;
mindestens einen Signalverstärker (28, 28'), der einen Eingang zum Empfangen des ratiometrischen Sensorsignals (26, 26') von dem Sensor (24) und einen Ausgang (O1, 02) zum Ausgeben eines Ausgabesignals (30, 30') aufweist, wobei der Signalverstärker (28, 28') geeignet ist, um das Ausgabesignal (30, 30') aus dem ratiometrischen Sensorsignal (26, 26') zu erzeugen, wobei das Verhältnis des Ausgabesignals (30, 30') zu dem ratiometrischen Sensorsignal (26, 26') durch einen einstellbaren Signalverstärkungsfaktor bestimmt wird; und
eine Steuerungseinheit (16), die analog einen Eingang zum Empfangen der Versorgungsspannung (12) von der Spannungsquelle aufweist, wobei die Steuerungseinheit (16) geeignet ist, um mindestens ein Steuerungssignal (18, 20) zum Einstellen des Spannungsverstärkungsfaktors und des Signalverstärkungsfaktors in Abhängigkeit von der Versorgungsspannung (12) zu erzeugen;
wobei der Spannungsverstärkungsfaktor umgekehrt proportional zu dem Signalverstärkungsfaktor ist; und
wobei die Steuerungseinheit (16) geeignet ist, um den Spannungsverstärkungsfaktor so weit zu reduzieren, dass die Betriebsspannung (22), die von dem Betriebsspannungsverstärker (14) bereitgestellt wird, innerhalb des zulässigen Betriebsspannungsbereichs liegt, wenn die Versorgungsspannung (12) eine maximal zulässige Betriebsspannung des ratiometrischen Sensors (24) überschreitet.

2. Elektrische Schaltung nach Anspruch 1,
wobei der Spannungsverstärkungsfaktor reziprok zu dem Signalverstärkungsfaktor ist.

3. Elektrische Schaltung nach Anspruch 1 oder 2,
wobei das ratiometrische Sensorsignal (26, 26') und das Ausgabesignal (30, 30') jeweils durch ein Spannungssignal gebildet werden; und wobei der Signalverstärker (28, 28') ein Spannungsverstärker ist.

4. Elektrische Schaltung nach einem der vorstehenden Ansprüche, wobei der Spannungsverstärkungsfaktor kleiner oder gleich 1 ist; und wobei der Signalverstärkungsfaktor größer oder gleich 1 ist.

5. Elektrische Schaltung nach einem der vorstehenden Ansprüche,
wobei die Schaltung mit einer Versorgungsspannung (12) betrieben werden kann, die innerhalb eines vorbestimmten Versorgungsspannungsbereichs liegt; wobei der Versorgungsspannungsbereich in eine Vielzahl von Intervallen unterteilt ist; wobei jedem Intervall ein jeweiliger vorbestimmter Spannungsverstärkungsfaktor und ein jeweiliger vorbestimmter Signalverstärkungsfaktor zugeordnet sind; wobei die Steuerungseinheit (16) geeignet ist, um dasjenige Intervall zu ermitteln, welches die Versorgungsspannung (12) umfasst; und wobei die Steuerungseinheit (16) geeignet ist, um das mindestens eine Steuerungssignal (18, 20) zum Einstellen des Spannungsverstärkungsfaktors und des Signalverstärkungsfaktors in Abhängigkeit von dem ermittelten Intervall zu erzeugen.

6. Elektrische Schaltung nach Anspruch 5,
wobei jedes Intervall und der diesem Intervall zugeordnete Spannungsverstärkungsfaktor derart gewählt sind, dass die von dem Betriebsspannungsverstärker (14) erzeugte Betriebsspannung (22) innerhalb des für den Sensor (24) zulässigen Betriebsspannungsbereichs liegt.

7. Elektrische Schaltung nach Anspruch 6,
wobei die Steuerungseinheit (16) mindestens einen Schwellenwertdetektor (36, 38) aufweist, der geeignet ist, um die Versorgungsspannung (12) mit mindestens einem Schwellenwert zu vergleichen, welcher benachbarte Intervalle voneinander trennt.

8. Elektrische Schaltung nach Anspruch 7,
wobei das Steuerungssignal (18) für das Einstellen des Spannungsverstärkungsfaktors und das Steuerungssignal (20) für das Einstellen des Signalverstärkungsfaktors eines jeweiligen Intervalls identisch sind.

9. Elektrische Schaltung nach einem der vorstehenden Ansprüche,
wobei der Betriebsspannungsverstärker (14) und/oder der Signalverstärker (28, 28') jeweils eine Spannungsteileranordnung umfassen, die eine Vielzahl schaltbarer Zweige aufweist, welche in Abhängigkeit von der Versorgungsspannung (12) selektiv derart schaltbar sind, dass eine variable Steuerungsspannung an einem Knoten (N, N', N") der jeweiligen Spannungsteileranordnung auf der Grundlage dessen bereitgestellt wird, ob der Spannungsverstärkungsfaktor oder der Signalverstärkungsfaktor eingestellt wird.

10. Elektrische Schaltung nach Anspruch 9,
wobei der Betriebsspannungsverstärker (14) eine Spannungsteileranordnung umfasst, die eine Vielzahl von Widerständen (R10 - R13) aufweist, und der Signalverstärker (28, 28') eine Spannungsteileranordnung umfasst, die eine Vielzahl von Widerständen (R10' - R13', R10" - R13") aufweist, wobei die Vielzahl der Widerstände (R10 - R13) des Betriebsspannungsverstärkers die gleichen Werte wie die Vielzahl der Widerstände (R10' - R13', R10" - R13") des Signalverstärkers aufweist.

11. Elektrische Schaltung nach Anspruch 9 oder 10,
wobei die jeweilige Spannungsteileranordnung eine Parallelschaltung einer Vielzahl von Widerständen (R11 - R13, R11' - R13', R11" - R13") umfasst, die von dem erwähnten Knoten (N, N', N") aus startet; wobei ein Schalter (M1A, M1 B, M2A, M2B, M2A', M2B') mindestens einem der Vielzahl von Widerständen zugeordnet ist, wobei durch diesen Schalter der jeweilige Widerstand (R11 - R13, R11' - R13', R11" - R13") für die Erzeugung der Steuerungsspannung aktiv oder nicht aktiv schaltbar ist, wobei der jeweilige Schalter (M1A, M1 B, M2A, M2B, M2A', M2B') in Abhängigkeit von der Versorgungsspannung (12) steuerbar ist.

12. Elektrische Schaltung nach einem der vorstehenden Ansprüche,
wobei die Schaltung (10, 10') den ratiometrischen Sensor (24) umfasst.

13. Elektrische Schaltung nach einem der vorstehenden Ansprüche,
wobei der ratiometrische Sensor ein Hall-Sensor (24) ist.

## Revendications

1. Circuit électrique pour faire fonctionner un capteur ratiométrique (24) qui est adapté à générer un signal de capteur ratiométrique (26, 26') sur la base d'un paramètre de mesure détecté et qui a une plage permise pour le voltage de fonctionnement, à l'extérieur de laquelle le signal de capteur (26, 26') n'est plus ratiométrique, comprenant :
un amplificateur de voltage de fonctionnement (14) qui possède une entrée pour recevoir un voltage d'alimentation (12) depuis une source de voltage, dans lequel l'amplificateur de voltage de fonctionnement (14) est adapté à générer un voltage fonctionnement (22) pour le capteur (24) depuis le voltage d'alimentation (12) fourni par la source de voltage, dans lequel le rapport du voltage de fonctionnement (22) sur le voltage d'alimentation (12) est déterminé par un facteur d'amplification de voltage susceptible d'être réglé ;
au moins un amplificateur de signal (28, 28') qui possède une entrée pour recevoir le signal de capteur ratiométrique (26, 26') depuis le capteur (24) et une sortie (O1, 02) pour sortir un signal de sortie (30, 30'), dans lequel l'amplificateur de signal (28, 28') est adapté à générer le signal de sortie (30, 30') à partir du signal de capteur ratiométrique (26, 26'), dans lequel le rapport du signal de sortie (30, 30') sur le signal de capteur ratiométrique (26, 26') est déterminé par un facteur d'amplification de signal susceptible d'être réglé ; et
une unité de commande (16) qui possède de manière analogue une entrée pour recevoir le voltage d'alimentation (12) depuis la source de voltage, dans lequel l'unité de commande (16) est adaptée à générer au moins un signal de commande (18, 20) pour régler le facteur d'amplification de voltage et le facteur d'amplification de signal en dépendance du voltage d'alimentation (12) ;
dans lequel le facteur d'amplification de voltage est inversement proportionnel au facteur d'amplification de signal ; et
dans lequel l'unité de commande (16) est adaptée à réduire le facteur d'amplification de voltage aussi loin que le voltage de fonctionnement (22) fourni par l'amplificateur de voltage de fonctionnement (14) tombe dans la plage de voltage de fonctionnement permissible quand le voltage d'alimentation (12) excède un voltage de fonctionnement permissible maximum du capteur ratiométrique (24).

2. Circuit électrique selon la revendication 1, dans lequel le facteur d'amplification de voltage est réciproque du facteur d'amplification de signal.

3. Circuit électrique selon la revendication 1 ou 2, dans lequel le signal de capteur ratiométrique (26, 26') et le signal de sortie (30, 30') sont formés par un signal de voltage respectif ; et dans lequel l'amplificateur de signal (28, 28') est un amplificateur de voltage.

4. Circuit électrique selon l'une quelconque des revendications précédentes, dans lequel le facteur d'amplification de voltage est inférieur ou égal à 1 ; et dans lequel le facteur d'amplification de signal est supérieur ou égal à 1.

5. Circuit électrique selon l'une quelconque des revendications précédentes, dans lequel le circuit peut être amené à fonctionner avec un voltage d'alimentation (12) qui tombe dans une plage de voltage d'alimentation prédéterminée ; dans lequel la plage de voltage d'alimentation est divisée en une pluralité d'intervalles ; dans lequel un facteur d'amplification de voltage prédéterminé respectif et un facteur d'amplification de signal prédéterminé respectif sont associés à chaque intervalle ; dans lequel l'unité de commande (16) est adaptée à déterminer l'intervalle qui comprend le voltage d'alimentation (12) ; et dans lequel l'unité de commande (16) est adaptée à générer au moins un signal de commande (18, 20) pour régler le facteur d'amplification de voltage et le facteur d'amplification de signal en dépendance de l'intervalle déterminé.

6. Circuit électrique selon la revendication 5, dans lequel chaque intervalle et le facteur d'amplification de voltage associé avec cet intervalle sont sélectionnés de telle façon que le voltage de fonctionnement (22) généré par l'amplificateur de voltage de fonctionnement (14) tombe dans la plage de voltage de fonctionnement permissible pour le capteur (24).

7. Circuit électrique selon la revendication 6, dans lequel l'unité de commande (16) comprend au moins un détecteur de valeur seuil (36, 38) qui est adapté à comparer le voltage d'alimentation (12) avec au moins une valeur seuil qui sépare des intervalles voisins les uns des autres.

8. Circuit électrique selon la revendication 7, dans lequel le signal de commande (18) pour le réglage du facteur d'amplification de voltage et le signal de commande (20) pour le réglage du facteur d'amplification de signal d'un intervalle respectif sont identiques.

9. Circuit électrique selon l'une quelconque des revendications précédentes, dans lequel l'amplificateur de voltage de fonctionnement (14) et/ou l'amplificateur de signal (28, 28') comprennent un agencement diviseur de voltage respectif ayant une pluralité de ramifications commutables qui peuvent être sélectivement commutées en dépendance du voltage d'alimentation (12) de telle façon qu'un voltage de commande variable est fourni à un noeud (N, N', N") de l'agencement diviseur de voltage respectif sur la base duquel est réglé le facteur d'amplification de voltage ou le facteur d'amplification de signal.

10. Circuit électrique selon la revendication 9, dans lequel l'amplificateur de voltage de fonctionnement (14) comprend un agencement diviseur de voltage ayant une pluralité de résistances (R10-R13) et l'amplificateur de signal (28, 28') comprend un agencement diviseur de voltage ayant une pluralité de résistances (R10'-R13', R10"-R13"), la pluralité de résistances (R10-R13) de l'amplificateur de voltage de fonctionnement ayant les mêmes valeurs que la pluralité de résistances (R10'-R13', R10"-R13") de l'amplificateur de signal.

11. Circuit électrique selon la revendication 9 ou 10, dans lequel l'agencement diviseur de voltage respectif comprend un circuit parallèle d'une pluralité de résistances (R11-R13, R11'-R13', R11"-R13") partant du noeud mentionné (N, N, N") ; dans lequel un commutateur (M1A, M1B, M2A, M2B, M2A', M2B') est associé avec l'une au moins de la pluralité de résistances, commutateur au moyen duquel la résistance respective (R11-R13, R11'-R13', R11"-R13") est commutable en situation active ou non active pour la génération du voltage de commande, le commutateur respectif (M1A, M1B, M2A, M2B, M2A', M2B') pouvant être commandé en dépendance du voltage d'alimentation (12).

12. Circuit électrique selon l'une quelconque des revendications précédentes, dans lequel le circuit (10, 10') comprend le capteur ratiométrique (24).

13. Circuit électrique selon l'une quelconque des revendications précédentes, dans lequel le capteur ratiométrique est un capteur de Hall (24).
